# DEMANDE DE BREVET EUROPEEN

(11) **EP 1 933 177 A1**
(43) Date de publication de la demande: **18.06.2008**
(21) Numéro de dépôt: 06125845.5
(22) Date de dépôt: 11.12.2006
(51) Int. Cl.: G02B 1/11, H01S 5/028

(54) **Amplificateur laser à cascades quantiques équipé d'un revêtement anti-réfléchissant comportant une strate réalisée en fluorure d'yttrium**

(71) Demandeur: Alpes Lasers S.A., 2000 Neuchâtel (CH)
(72) Inventeur: Maulini, Richard, 2000 Neuchâtel (CH); Blaser, Stéphane, 2072, St-Blaise (CH); Faist, Jérôme, 2072 St-Blaise (CH); Blaser, Stéphane, 2072 St-Blaise (CH)
(74) Mandataire: GLN

(57) **Abrégé**

L'invention concerne un amplificateur laser (12) à cascades quantiques qui comporte une zone active (20) qui est formée par un empilement de couches de matériaux semi-conducteurs crues de manière épitaxiale sur une couche d'un substrat (16) de phosphure d'indium (InP) ou d'arsenure de gallium (GaAs) qui porte la zone active (20), et un revêtement vertical anti-réfléchissant (34) qui recouvre une face de sortie (28) du rayonnement laser, constitué de matérieux d'indices de réfraction données et d'épaisseurs déterminées de manière à laisser passer la totalité du rayonnement laser à travers la face de sortie; le revêtement anti-réfléchissant (34) comportant une première strate (36) ayant un premier indice de réfraction (ni) inférieur à l'indice de réfraction déterminé (n_{D}), et au moins une deuxième strate (38) ayant un deuxième indice de réfraction (n₂) supérieur à l'indice de réfraction déterminé (n_{D}), caractérisé en ce que la première strate (36) du revêtement anti-réfléchissant (34) est réalisée en fluorure d'yttrium (YF₃).

## Description

### Domaine technique

L'invention concerne un amplificateur laser à cascades quantiques qui comporte une face de sortie sur laquelle est appliqué un revêtement anti-réfléchissant.

L'invention concerne plus particulièrement un amplificateur laser à cascades quantiques, qui est susceptible d'émettre un rayonnement laser infrarouge, et qui comporte :
- une zone active qui est formée par un empilement vertical de couches horizontales de matériaux semi-conducteurs crues de manière épitaxiale sur un substrat de phosphure d'indium (InP) ou un substrat d'arséniure de gallium (GaAs);
- un revêtement vertical anti-réfléchissant qui recouvre une face verticale d'extrémité de sortie du rayonnement laser et qui présente un indice de réfraction déterminé de manière à laisser passer la totalité du rayonnement laser à travers la face de sortie, le revêtement anti-réfléchissant comportant :
   - au moins une première strate ayant un premier indice de réfraction inférieur à l'indice de réfraction déterminé ;
   - et au moins une deuxième strate ayant un deuxième indice de réfraction supérieur à l'indice de réfraction déterminé.

### Etat de la technique

Les lasers du type à cascades quantiques sont déjà connus de l'état de la technique. Un exemple d'un laser à cascades quantiques est notamment divulgué en détail dans le document EP-A1-1.195.865.

Ce type de laser comporte généralement un amplificateur semi-conducteur, tel qu'une puce ou une diode laser, qui est associé à une cavité de résonance, dite de Fabry-Pérot.

Lorsqu'un courant électrique lui est appliqué, l'amplificateur laser émet un rayonnement laser. La cavité de résonance comporte un premier moyen pour réfléchir au moins en partie le rayonnement laser en direction d'un deuxième moyen de réflexion en passant à travers l'amplificateur laser. Le deuxième moyen de réflexion réfléchit à nouveau le rayonnement laser en direction du premier moyen de réflexion via l'amplificateur. Le rayonnement laser effectue ainsi des allers retours successifs dans l'amplificateur laser, ce qui provoque l'amplification du rayonnement laser.

Il est connu de réaliser une cavité de Fabry-Pérot interne au laser. Les moyens de réflexion sont alors formés par des faces verticales opposées clivées de l'amplificateur laser dont l'une au moins forme la face de sortie du rayonnement laser.

Il est aussi connu de réaliser une cavité de Fabry-Pérot externe. Le premier moyen de réflexion, tel qu'un miroir semi-réfléchissant, est alors agencé à l'extérieur du laser, sur la trajectoire du rayonnement laser. Ce miroir permet de réfléchir le rayonnement laser émis par la face de sortie de nouveau vers la face de sortie du laser. Le rayonnement réfléchi entre ainsi dans l'amplificateur laser, puis il est réfléchi par le deuxième moyen de réflexion qui peut être formé par une face réfléchissante clivée opposée à la face de sortie. A chaque passage à travers l'amplificateur laser, le rayonnement laser est ainsi amplifié.

Un tel laser à cascades quantiques émet par exemple un rayonnement laser multimode, un mode correspondant à une longueur d'onde lumineuse composant le rayonnement laser. La longueur d'onde lumineuse de chaque mode est comprise dans l'intervalle des infrarouges proches et moyens, c'est-à-dire entre 3 et 18 µm.

Il est connu d'utiliser un élément dispersif, par exemple un réseau de diffraction dans un laser à cavité externe afin de filtrer spectralement le rayonnement réfléchi dans l'amplificateur laser pour produire un rayonnement laser globalement monomode.

Pour augmenter la gamme d'accordage d'un tel laser et faciliter un accordage continu, il est préférable que la face de sortie du laser laisse passer entièrement le rayonnement laser sans en réfléchir une partie vers l'intérieur de l'amplificateur laser, ce qui perturberait l'accordage. En effet, l'amplificateur laser formerait alors une cavité parasite interne de résonance comprise dans la cavité externe, provoquant l'apparition de modes parasites.

Or, lorsque la face de sortie n'est pas traitée, la différence entre l'indice de réfraction n_{L} du milieu amplificateur constituant l'amplificateur laser, qui est par exemple compris entre 3,15 et 3,22, et l'indice de réfraction de l'air qui est égal à 1, provoque la réflexion d'une partie du rayonnement laser incident, la réflectivité de la face de sortie est alors environ de 27%, la réflectivité étant calculée selon la formule (n_{L}-1)² / (n_{L}+1)².

Pour résoudre ce problème, il est connu d'appliquer sur la face de sortie du laser un revêtement de matériau anti-réfléchissant dont l'indice de réfraction soit proche d'un indice de réfraction idéal déterminé, par exemple ici 1,8. Cet indice de réfraction idéal est déterminé par le calcul de la réflectivité à une interface entre deux matériaux, ici l'air d'indice de réfraction n_{A}=1 et le substrat d'indice de réfraction n_{L} et on obtient: *n_{D}* =√*n_{L}*.

Il est ainsi connu d'appliquer un revêtement d'alumine (Al₂O₃) sur la face de sortie du laser. Un tel revêtement ne permet cependant pas de laisser passer la totalité du rayonnement laser infrarouge car son indice de réfraction est trop éloigné de l'indice de réfraction idéal déterminé. Ainsi, un tel revêtement anti-réfléchissant est adapté pour des longueurs d'ondes comprises dans l'infrarouge proche, c'est-à-dire entre 1 et 2 µm, mais pas pour des longueurs d'ondes comprises dans l'infrarouge moyen, c'est-à-dire entre 3 et 18 µm.

De tels revêtements sont notamment divulgués dans le document Applied Physics Letters, Volume 78, p.2834, datant de l'année 2001, intitulé "Grating-tuned external-cavity quantum-cascade semiconductors lasers" (G.P. Luo et al.), ainsi que dans le document Optics Letters, Volume 30, p.2584, datant de l'année 2005, et intitulé "Continuous-wave operation of a broadly tunable thermoelectrically cooled external cavity quantum-cascade laser" (R. Maulini et al.).

On connaît aussi des revêtements réalisés en d'autres matériaux, cependant ces matériaux présentent l'inconvénient de ne pas adhérer correctement aux couches de matériaux constituant l'amplificateur.

### Divulgation de l'invention

La présente invention vise donc à résoudre ces problèmes en proposant un laser du type décrit précédemment, caractérisé en ce que la première strate du revêtement anti-réfléchissant est réalisée en fluorure d'yttrium (YF3).

Selon d'autres caractéristiques de l'invention :
- la première strate du revêtement anti-réfléchissant est interposée entre la face de sortie de l'amplificateur laser et la deuxième strate ;
- la deuxième strate est réalisée en séléniure de zinc (ZnSe) ;
- la deuxième strate est réalisée en sulfure de zinc (ZnS) ;
- la deuxième strate est réalisée en oxyde de niobium (Nb2O5) ;
- la deuxième strate est réalisée en nitrure de silicium (Si3N4) ;
- l'amplificateur laser émet un rayonnement laser multimode dans l'infrarouge proche et/ou moyen dont les longueurs d'onde sont comprises entre 3 et 18 µm ;
- les épaisseurs des première et deuxième strates du revêtement anti-réfléchissant sont déterminées en fonction des longueurs d'ondes du rayonnement laser.

### Brève description des dessins

D'autres caractéristiques et avantages apparaîtront au cours de la lecture de la description détaillée qui va suivre pour la compréhension de laquelle on se reportera aux dessins annexés parmi lesquels :
- la figure 1 est une vue en coupe qui représente schématiquement un laser à cascades quantiques comportant un amplificateur laser équipé d'un revêtement anti-réfléchissant réalisé selon les enseignements de l'invention ;
- la figure 2 est un graphique qui comporte des courbes représentant l'épaisseur des couches constituant le revêtement anti-réfléchissant réalisé selon les enseignements de l'invention en fonction du nombre d'onde du laser ;
- la figure 3 est un graphique qui comporte des courbes représentant l'épaisseur des couches constituant le revêtement anti-réfléchissant réalisé selon un deuxième mode de réalisation de l'invention en fonction du nombre d'onde du laser;

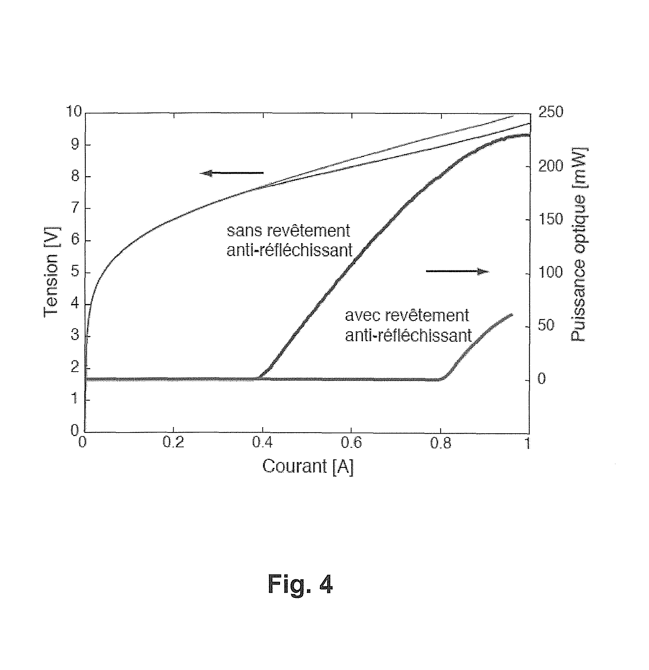

- la figure 4 est un graphique montrant l'effet du revêtement anti-réfléchissant réalisé selon les enseignements de l'invention sur les performances d'un amplificateur laser montrant que la réflectivité de la face de sortie est presque nulle, ce qui a pour effet de fortement diminuer l'amplification laser (augmentation du courant de seuil).

### Mode(s) de réalisation de l'invention

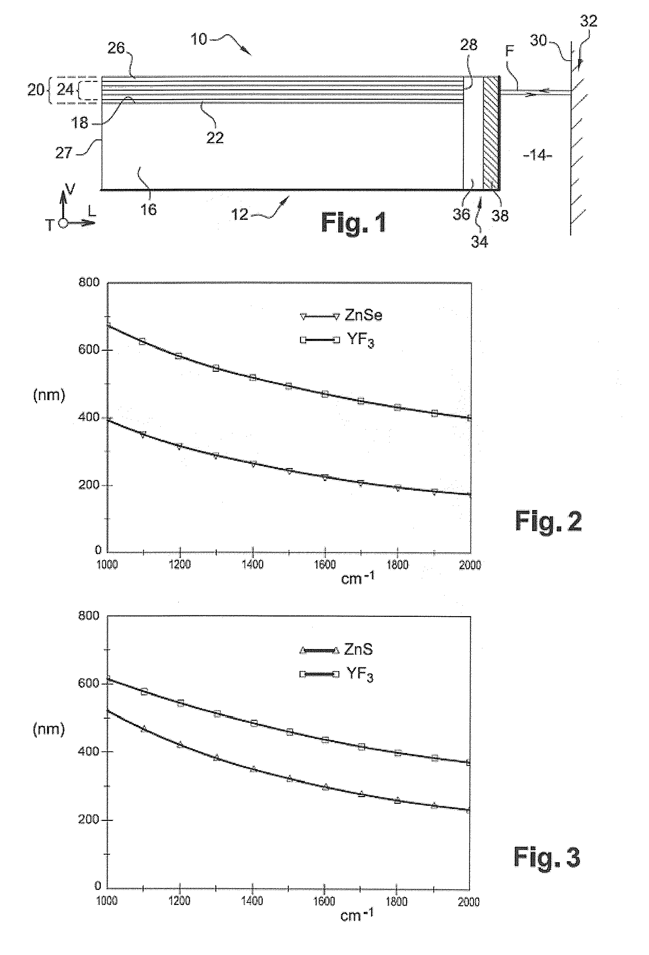

Pour la suite de la description et pour les revendications, on adoptera à titre non limitatif une orientation longitudinale, verticale et transversale indiquée par le trièdre "L,V,T" de la figure 1.

Par la suite, des éléments identiques, analogues ou similaires seront désignés par des mêmes numéros de référence.

On a représenté à la figure 1 un laser à cascade quantique 10 qui comporte un amplificateur laser 12 qui est agencé dans une cavité externe de résonance 14.

L'amplificateur laser 12 se présente ici sous la forme d'un bloc, d'une barrette, d'une diode ou d'une puce horizontale qui est réalisé avec un empilement de différentes couches de matériaux semi-conducteurs.

De manière connue, l'amplificateur laser 12 comporte une couche horizontale inférieure de substrat 16. Sur une face supérieure 18 de ce substrat 16 est agencée une zone active 20 qui est formée par un empilement vertical de couches horizontales de matériaux semi-conducteurs.

Le substrat 16 est susceptible de remplir une fonction d'électrode.

La zone active 20 comporte plus particulièrement, de bas en haut en se reportant à la figure 1, une première couche inférieure 22 de confinement optique, une région de gain 24 et une deuxième couche supérieure de confinement optique 26.

La région de gain 24 est formée d'une pluralité de couches formant successivement des puits quantiques et des barrières quantiques. La région de gain 24 comporte aussi des barrières d'injection. Pour une description plus détaillée d'une telle zone active 20 et de sa composition, on pourra se reporter au document EP-A1-1.195.865 précité.

Lorsque la région de gain 24 est alimentée avec un courant électrique adapté par l'intermédiaire du substrat 16 et des couches de confinement optique 22, 26, un rayonnement laser est créé dans la région de gain 24.

Les couches de confinement optique 22, 26 forment un guide horizontal d'ondes qui est destiné à guider la propagation du rayonnement laser dans la région de gain 24 selon une direction longitudinale.

Toutes les couches de l'amplificateur laser 12 ont une structure monocristalline de même maille dans le plan horizontal afin que l'amplificateur laser 12 ne se délite pas.

Le substrat 16 est réalisé à base d'indium, et plus particulièrement en phosphure d'indium (InP) monocristallin. Le substrat 16 est éventuellement dopé pour améliorer ses propriétés de conduction d'électricité.

Selon une variante non représentée de l'invention, le substrat 16 est réalisé en un alliage monocristallin d'arseniure de Gallium (GaAs).

Les différentes couches de la zone active 20 sont aussi réalisées en matériaux semi-conducteurs monocristallins crûs de manière épitaxiale sur le substrat.

Une telle composition permet de définir une structure cristalline de même maille dans le plan horizontal et identique à celle du substrat 16 en InP. Ainsi, l'amplificateur laser 12 présente une structure cristalline homogène de manière que les différentes couches ne se délitent pas.

De manière connue, certaines couches peuvent être dopées, par exemple avec du silicium (Si).

L'amplificateur laser 12 est délimité longitudinalement par une face verticale transversale d'extrémité arrière 27 et par une face verticale transversale d'extrémité avant 28. Les deux faces avant 28 et arrière 27 sont parallèles. Ces faces 27, 28 sont réalisées par clivage du matériau cristallin formant l'amplificateur laser 12.

La face avant 28 forme une face de sortie du rayonnement laser produit dans la région de gain 24, et la face arrière 27 forme une face de réflexion du rayonnement laser qui est destinée à réfléchir le rayonnement laser vers l'intérieur de la région de gain 24, comme indiqué par les flèches "F" de la figure 1.

Une face verticale transversale semi-réfléchissante 30 d'un miroir externe 32 est agencée en vis-à-vis et en avant de la face de sortie 28 de l'amplificateur laser 12. La face semi-réfléchissante 30 du miroir externe 32 est susceptible de réfléchir au moins une partie du rayonnement laser sortant par la face de sortie 28 de l'amplificateur laser 12.

L'espace qui est compris longitudinalement entre la face semi-réfléchissante 30 du miroir externe 32 et la face arrière de réflexion 27 de l'amplificateur laser 12 forme la cavité externe de résonance 14 de l'amplificateur laser 12.

Un tel laser est susceptible d'émettre un rayonnement laser multimode à des longueurs d'ondes comprises dans l'infrarouge proche et moyen entre 3 et 18 µm.

Pour la suite de la description, on définit le nombre d'onde d'un mode de rayonnement laser comme étant l'inverse de sa longueur d'onde. Ainsi les nombres d'onde de l'infrarouge moyen sont compris entre 555 et 3333 cm⁻¹.

Lorsque la face de sortie 28 de l'amplificateur laser 12 n'est pas traitée, la différence entre l'indice de réfraction "n_{L}" de l'amplificateur laser 12, qui est compris entre 3,15 et 3,22 pour la composition donnée en exemple, et l'indice de réfraction de l'air ambiant "n_{A}", qui est globalement égal à 1, provoque la réflexion d'une partie du rayonnement laser incident, par exemple la réflectivité est d'environ 27%.

L'invention propose d'appliquer sur la face de sortie 28 de l'amplificateur laser 12 un revêtement 34 vertical transversal anti-réfléchissant particulièrement performant susceptible de laisser passer une grande gamme de rayonnement laser infrarouge proche et moyen. Le revêtement anti-réfléchissant 34 présente un indice de réfraction qui est proche d'un indice de réfraction idéal déterminé "n_{D}" de manière à laisser passer la totalité du rayonnement laser. L'indice de réfraction idéal déterminé "n_{D}" est par exemple égal à 1,8 pour l'amplificateur laser 12 donné en exemple.

Selon les enseignements de l'invention, le revêtement anti-réfléchissant 34 est formé d'une première strate 36 verticale transversale présentant un premier indice de réfraction "n₁" qui est inférieur à l'indice de réfraction idéal déterminé "n_{D}", et une deuxième strate 38 verticale transversale présentant un deuxième indice de réfraction "n₂" qui est supérieur à l'indice de réfraction idéal déterminé "n_{D}".

La première strate 36 est interposée entre la face de sortie 28 et la deuxième strate 38. Ainsi, la première strate 36 est agencée directement en contact avec la face de sortie 28 de l'amplificateur laser 12.

La première strate 36 du revêtement anti-réfléchissant 34 est réalisée en fluorure d'yttrium (YF₃). La première strate 36 présente ainsi un indice de réfraction "n₁" qui est inférieur à l'indice de réfraction idéal déterminé "n_{D}". De plus, la première strate 36 du revêtement anti-réfléchissant 34 ainsi réalisée adhère parfaitement à la face de sortie 28 de l'amplificateur laser 12.

La deuxième strate 38 du revêtement anti-réfléchissant 34 est réalisée en séléniure de zinc (ZnSe). La deuxième strate 38 présente ainsi un indice de réfraction "n₂" qui est supérieur à l'indice de réfraction idéal déterminé "n_{D}". La deuxième strate 38 ainsi réalisée adhère parfaitement à la première strate 36.

L'indice de réfraction "n₁, n₂" de chacune des strates 36, 38 du revêtement anti-réfléchissant 34 est fonction de la longueur d'onde du rayonnement laser considéré. L'épaisseur des strates pour obtenir une réflectivité nulle est déterminée en fonction de la longueur d'onde du rayonnement laser considéré. Le calcul des épaisseurs adaptées aux nombres d'onde du rayonnement laser met en oeuvre un calcul de réflectivité connu qui est par exemple divulgué dans le livre intitulé "Optoélectronique" (E. Rosencher, B. Vinter), édition Masson, Paris, édition de 1998, chapitre 9.

L'épaisseur, en nanomètres, des première 36 et deuxième 38 strates à déposer sur la face de sortie 28 pour obtenir un revêtement anti-réfléchissant 34 de réflectivité nulle pour différents nombres d'onde, en cm⁻¹, est indiqué dans le "tableau 1" suivant correspondant à la figure 2 :

**Tableau 1**

| Nombre d'onde (cm⁻¹) | Epaisseur de la première strate 36 en YF₃ (nm) | Epaisseur de la deuxième strate 38 en ZnSe (nm) |
|---|---|---|
| 1000 | 674 | 391 |
| 1100 | 624 | 348 |
| 1200 | 583 | 313 |
| 1300 | 547 | 284 |
| 1400 | 517 | 258 |
| 1500 | 490 | 237 |
| 1600 | 467 | 218 |
| 1700 | 445 | 201 |
| 1800 | 426 | 187 |
| 1900 | 408 | 175 |
| 2000 | 391 | 164 |

On remarque ainsi que le revêtement anti-réfléchissant 34 ainsi réalisé est totalement transparent pour un rayonnement laser dont les modes ont un nombre d'onde compris dans l'infrarouge moyen.

Selon une variante non représentée de l'invention, la deuxième strate 38 est réalisée en sulfure de zinc (ZnS). Ce matériau présente en effet des propriétés de réfraction et d'adhérence analogues à celle du séléniure de zinc.

L'épaisseur, en nanomètres, des première 36 et deuxième 38 strates à déposer sur la face de sortie 28 pour obtenir un revêtement anti-réfléchissant 34 de réflectivité nulle pour différents nombres d'onde, en cm⁻¹, est indiqué dans le "tableau 2" suivant correspondant à la figure 3 :

**Tableau 2**

| Nombre d'onde (cm⁻¹) | Epaisseur de la première strate 36 en YF₃ (nm) | Epaisseur de la deuxième strate 38 en ZnS (nm) |
|---|---|---|
| 1000 | 607 | 507 |
| 1100 | 564 | 453 |
| 1200 | 527 | 408 |
| 1300 | 496 | 370 |
| 1400 | 470 | 338 |
| 1500 | 446 | 310 |
| 1600 | 426 | 286 |
| 1700 | 407 | 265 |
| 1800 | 390 | 247 |
| 1900 | 374 | 231 |
| 2000 | 359 | 217 |

Selon encore une autre variante non représentée de l'invention, d'autres matériaux présentant des propriétés analogues peuvent être employés pour réaliser la deuxième strate 38 du revêtement anti-réfléchissant 34, par exemple du Nb₂O₅, ou du Si₃N₄.

Les strates 36, 38 du revêtement anti-réfléchissant 34 sont déposées sur la face de sortie 28 de l'amplificateur laser 12 dans une chambre de déposition sous vide par évaporation thermique, par évaporation par canon à électron ou par pulvérisation cathodique par exemple. L'épaisseur de chaque strate 36, 38 du revêtement anti-réfléchissant 34 est mesurée pendant la déposition au moyen d'une balance à quartz.

L'amplificateur laser 12 équipé d'un revêtement anti-réfléchissant 34 réalisé selon les enseignements de l'invention permet d'obtenir une réflectivité nulle pour une gamme élargie de longueurs d'onde du rayonnement laser comprises dans l'infrarouge, et plus particulièrement dans l'infrarouge moyen.

De plus, la première strate 36 réalisée en YF₃ est parfaitement adhérente à la face de sortie 28 et elle ne risque pas de se décoller ou de se déliter de la face de sortie 28.

De même, la deuxième strate 38 du revêtement anti-réfléchissant 34 est parfaitement adhérente à la première strate 36.

Selon une variante non représentée de l'invention et par analogie avec la figure 1, la deuxième strate 38 est interposée entre la face de sortie 28 et la première strate 38. Ainsi, la deuxième strate 38 est agencée directement en contact avec la face de sortie 28 de l'amplificateur laser 12.

Les matériaux utilisés pour réaliser la deuxième strate 38 sont aussi parfaitement adhérents à la face de sortie 28.

Selon une variante non représentée de l'invention, le revêtement anti-réfléchissant 38 comporte plus de deux strates. Au moins une première strate est alors réalisée en fluorure d'yttrium, tandis que les deuxièmes strates sont réalisées comme décrit précédemment.

## Revendications

1. Amplificateur laser (12) à cascades quantiques, qui est susceptible d'émettre un rayonnement laser infrarouge, et qui comporte :
- une couche horizontale inférieure d'un substrat (16) en phosphure d'indium (InP);
- une zone active (20) qui est formée par un empilement vertical de couches horizontales de matériaux semi-conducteurs crues de manière épitaxiale sur le substrat (16) ;
- un revêtement vertical anti-réfléchissant (34) qui recouvre une face verticale d'extrémité de sortie (28) du rayonnement laser et qui présente un indice de réfraction déterminé (n_{D}) de manière à laisser passer la totalité du rayonnement laser à travers la face de sortie, le revêtement anti-réfléchissant (34) comportant :
- au moins une première strate (36) ayant un premier indice de réfraction (n₁) inférieur à l'indice de réfraction déterminé (n_{D}) ;
- et au moins une deuxième strate (38) ayant un deuxième indice de réfraction (n₂) supérieur à l'indice de réfraction déterminé (n_{D}) ;
**caractérisé en ce que** la première strate (36) du revêtement anti-réfléchissant (34) est réalisée en fluorure d'yttrium (YF₃).

2. Amplificateur laser (12) selon la revendication précédente, **caractérisé en ce que** la première strate (36) du revêtement anti-réfléchissant (34) est interposée entre la face de sortie (28) de l'amplificateur laser (12) et la deuxième strate (38).

3. Amplificateur laser (12) selon l'une quelconque des revendications précédentes, **caractérisé en ce que** la deuxième strate (38) est réalisée en séléniure de zinc (ZnSe).

4. Amplificateur laser (12) selon l'une quelconque des revendications 1 ou 2, **caractérisé en ce que** la deuxième strate (38) est réalisée en sulfure de zinc (ZnS).

5. Amplificateur laser (12) selon l'une quelconque des revendications 1 ou 2, **caractérisé en ce que** la deuxième strate (38) est réalisée en oxyde de niobium (Nb₂O₅).

6. Amplificateur laser (12) selon l'une quelconque des revendications 1 ou 2, **caractérisé en ce que** la deuxième strate (38) est réalisée en nitrure de silicium (Si₃N₄).

7. Amplificateur laser (12) selon l'une quelconque des revendications précédentes, **caractérisé en ce que** l'amplificateur laser (12) émet un rayonnement laser multimode dans l'infrarouge proche et/ou moyen dont les longueurs d'onde sont comprises entre 3 et 18 µm.

8. Amplificateur laser (12) selon l'une quelconque des revendications précédentes, **caractérisé en ce que** les épaisseurs des première (36) et deuxième (38) strates du revêtement anti-réfléchissant (34) sont déterminées en fonction des longueurs d'ondes du rayonnement laser.

9. Amplificateur laser (12) à cascades quantiques, qui est susceptible d'émettre un rayonnement laser infrarouge, et qui comporte :
- une couche horizontale inférieure d'un substrat (16) en arséniure de gallium (GaAs);
- une zone active (20) qui est formée par un empilement vertical de couches horizontales de matériaux semi-conducteurs crues de manière épitaxiale sur le substrat (16) ;
- un revêtement vertical anti-réfléchissant (34) qui recouvre une face verticale d'extrémité de sortie (28) du rayonnement laser et qui présente un indice de réfraction déterminé (n_{D}) de manière à laisser passer la totalité du rayonnement laser à travers la face de sortie, le revêtement anti-réfléchissant (34) comportant :
- au moins une première strate (36) ayant un premier indice de réfraction (n₁) inférieur à l'indice de réfraction déterminé (n_{D}) ;
- et au moins une deuxième strate (38) ayant un deuxième indice de réfraction (n₂) supérieur à l'indice de réfraction déterminé (n_{D}) ;
**caractérisé en ce que** la première strate (36) du revêtement anti-réfléchissant (34) est réalisée en fluorure d'yttrium (YF₃).

10. Amplificateur laser (12) selon la revendication précédente, **caractérisé en ce que** la première strate (36) du revêtement anti-réfléchissant (34) est interposée entre la face de sortie (28) de l'amplificateur laser (12) et la deuxième strate (38).

11. Amplificateur laser (12) selon l'une quelconque des revendications 9 ou 10, **caractérisé en ce que** la deuxième strate (38) est réalisée en séléniure de zinc (ZnSe).

12. Amplificateur laser (12) selon l'une quelconque des revendications 9 ou 10, **caractérisé en ce que** la deuxième strate (38) est réalisée en sulfure de zinc (ZnS).

13. Amplificateur laser (12) selon l'une quelconque des revendications 9 ou 10, **caractérisé en ce que** la deuxième strate (38) est réalisée en oxyde de niobium (Nb₂O₅).

14. Amplificateur laser (12) selon l'une quelconque des revendications 9 ou 10, **caractérisé en ce que** la deuxième strate (38) est réalisée en nitrure de silicium (Si₃N₄).

15. Amplificateur laser (12) selon l'une quelconque des revendications 9 à 14, **caractérisé en ce que** l'amplificateur laser (12) émet un rayonnement laser multimode dans l'infrarouge proche et/ou moyen dont les longueurs d'onde sont comprises entre 3 et 18 µm.

16. Amplificateur laser (12) selon l'une quelconque des revendications 9 à 15, **caractérisé en ce que** les épaisseurs des première (36) et deuxième (38) strates du revêtement anti-réfléchissant (34) sont déterminées en fonction des longueurs d'ondes du rayonnement laser.
